# EUROPEAN PATENT APPLICATION

(11) **EP 4 801 245 A1**
(43) Date of publication of application: **02.09.2026**
(21) Application number: 25781620.7
(22) Date of filing: 28.03.2025
(51) Int. Cl.: H10K 59/35, H10K 59/12, H10K 59/123

(54) **DISPLAY PANEL AND DISPLAY DEVICE**

(30) Priority: 02.04.2024 CN 202410399118
(71) Applicant: Wuhan Tianma Microelectronics Co., Ltd. Shanghai Branch, Shanghai 201201 (CN); Wuhan Tianma Microelectronics Co., Ltd., Wuhan, Hubei 430205 (CN)
(72) Inventor: XIN, Yu, Shanghai 201201 (CN); CHEN, Xian, Shanghai 201201 (CN)
(74) Representative: Völkl Siebenson Patentanwälte - Partnerschaft mbB
(86) International application number: PCT/CN2025/085575
(87) International publication number: WO 2025/209323

(57) **Abstract**

A display panel and a display device. The display panel comprises a base substrate, and a pixel circuit layer, an insulating layer, and a display function layer which are sequentially stacked on one side of the base substrate. A first through hole, a second through hole, and a third through hole in the insulating layer are arranged respectively corresponding to a first light-emitting element, a second light-emitting element, and a third light-emitting element of the display function layer, and the projections of center points of the first through hole, the second through hole, and the third through hole on the base substrate are a point A, a point B, and a point C respectively. The point A, the point B, and the point C are arranged in a first direction, the distance between the point A and the point B is a, the distance between the point B and the point C is b, and a is not equal to b; or the point A and the point B are located on a straight line parallel to the first direction, and the point C is located outside the straight line where the point A and the point B are located.

## Description

This application claims priority to Chinese Patent Application No. 202410399118.X filed on Apr. 2, 2024 with the China National Intellectual Property Administration (CNIPA), the disclosure of which is incorporated herein by reference in its entirety.

### TECHNICAL FIELD

Embodiments of the present disclosure relate to the field of display technologies and, in particular, a display panel and a display device.

### BACKGROUND

In an organic light-emitting diode (OLED) display panel, since pixel circuits are arranged in an array, through holes for electrically connecting the pixel circuits to anodes of the light-emitting elements are usually spaced equally and arrayed at the same horizontal level. However, this design is prone to causing the aperture loss of the light-emitting regions of the light-emitting elements, leading to a shorter service life and a worse color difference of the light-emitting elements and affecting the display effect of the display panel.

### SUMMARY

The present disclosure provides a display panel and a display device. The positions of the through holes to which the anodes of subpixels are connected are optimized such that the through holes are spaced unequally or arrayed nonlinearly, avoiding the subpixel aperture area loss caused by the through holes, improving the aperture ratio and the service life of the subpixels, alleviating the color cast caused by the service life of the light-emitting elements, and improving the display effect of the display panel.

In a first aspect, embodiments of the present disclosure provide a display panel. The display panel includes a substrate; and a pixel circuit layer, an insulating layer, and a display function layer that are stacked in sequence on one side of the substrate.

The pixel circuit layer includes multiple pixel circuits arranged in an array. The insulating layer includes multiple through holes. The through holes are filled with conductive structures. The display function layer includes multiple light-emitting elements. The pixel circuits are electrically connected to the light-emitting elements by the conductive structures.

The display panel includes multiple pixel units. Each pixel unit includes a first light-emitting element, a second light-emitting element, and a third light-emitting element that emit different colors of light. The through holes include a first through hole, a second through hole, and a third through hole that are arranged corresponding to the first light-emitting element, the second light-emitting element, and the third light-emitting element respectively. The projection of the central point of the first through hole on the substrate, the projection of the central point of the second through hole on the substrate, and the projection of the central point of the third through hole on the substrate are point A, point B, and point C respectively.

Points A, B, and C are arranged in a first direction. The distance between point A and point B is a. The distance between point B and point C is b. a ≠ b. The first direction is parallel to the row direction or the column direction of the array formed by the plurality of pixel circuits.

In a second aspect, based on the same inventive concept, embodiments of the present disclosure provide a display panel. The display panel includes a substrate; and a pixel circuit layer, an insulating layer, and a display function layer that are stacked in sequence on one side of the substrate.

The pixel circuit layer includes multiple pixel circuits arranged in an array. The insulating layer includes multiple through holes filled with conductive structures. The display function layer includes multiple light-emitting elements. The pixel circuits are electrically connected to the light-emitting elements by the conductive structures.

The display panel includes multiple pixel units. Each pixel unit includes a first light-emitting element, a second light-emitting element, and a third light-emitting element that emit different colors of light. The through holes include a first through hole, a second through hole, and a third through hole that are arranged corresponding to the first light-emitting element, the second light-emitting element, and the third light-emitting element respectively. The projection of the central point of the first through hole on the substrate, the projection of the central point of the second through hole on the substrate, and the projection of the central point of the third through hole on the substrate are point A, point B, and point C respectively.

Points A, B, and C are arranged in a first direction. Points A and B are located in a straight line parallel to the first direction. Point C is located outside the straight line where points A and B are located. The first direction is parallel to the row direction or the column direction of the array formed by the plurality of pixel circuits.

In a third aspect, based on the same inventive concept, embodiments of the present disclosure also provide a display device. The display device includes the display panel of the first aspect or the second aspect.

### BRIEF DESCRIPTION OF DRAWINGS

FIG. 1 is a structural diagram of a display panel according to an embodiment.
FIG. 2 is a sectional view taken along direction EE' of FIG. 1.
FIG. 3 is a structural diagram of a display panel according to embodiments of the present disclosure.
FIG. 4 is a sectional view taken along direction FF' of FIG. 3.
FIG. 5 is a structural diagram of another display panel according to embodiments of the present disclosure.
FIG. 6 is a structural diagram of another display panel according to embodiments of the present disclosure.
FIG. 7 is an enlarged view of two adjacent pixel units in FIG. 6.
FIG. 8 is a structural diagram of another display panel according to embodiments of the present disclosure.
FIG. 9 is a sectional view taken along direction GG' of FIG. 8.
FIG. 10 is an enlarged view of a single pixel unit in FIG. 8.
FIG. 11 is a structural diagram of a display device according to embodiments of the present disclosure.

### DETAILED DESCRIPTION

The present disclosure is further described in detail below in conjunction with drawings and embodiments. It is to be understood that the embodiments described here are intended to illustrate the present disclosure and not to limit the present disclosure. Additionally, it is to be noted that for ease of description, only part, not all, of structures related to the present disclosure are illustrated in the drawings. It is apparent to those skilled in the art that various modifications and variations can be made to the present disclosure without departing from the spirit or scope of the present disclosure. Therefore, the present disclosure is intended to cover modifications and variations of the present disclosure that fall within the scope of the corresponding claims (the claimed technical solutions) and equivalents thereof. It is to be noted that if not in collision, embodiments of the present disclosure may be combined with each other.

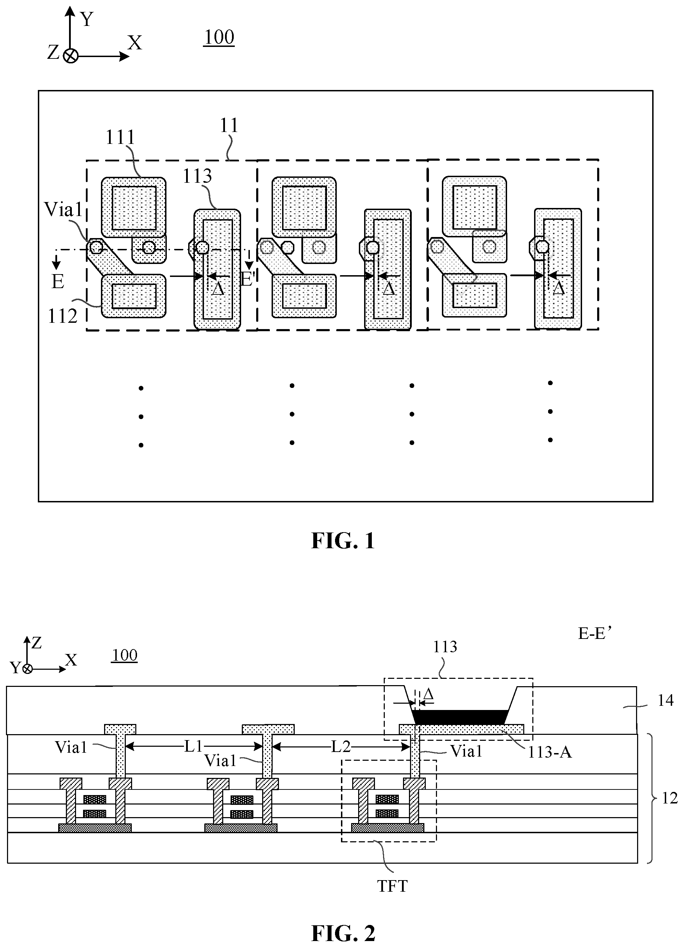

FIG. 1 is a structural diagram of a display panel according to the related art. FIG. 2 is a sectional view taken along direction EE' of FIG. 1. Referring to FIG. 1 and FIG. 2, a display panel 100, especially a wearable display panel, usually uses the Real pyramid pixel arrangement. That is, each pixel unit 11 of the display panel 100 includes three display subpixels, such as a first subpixel 111, a second subpixel 112, and a third subpixel 113 shown in FIG. 1. Multiple pixel units 11 of the display panel 100 are arranged in an array. Illustratively, generally the first subpixel 111 is a green subpixel (G), the second subpixel 112 is a red subpixel (R), and the third subpixel 113 is a blue subpixel (B). Referring to FIG. 2, the pixel circuit 12 of the display panel 100 includes multiple thin-film transistors (TFTs) (only one thin-film transistor is shown) and film structures (not shown) including storage capacitors and metal wires. Each thin-film transistor is electrically connected to the anode of a subpixel by a through hole Vial and configured to provide a drive voltage to the subpixel to drive the subpixel to emit light. The through hole Vial may be referred to as a through hole in direct contact with the anode. FIG. 2 shows that the thin-film transistor in the pixel circuit is electrically connected to the anode 113-A of the third subpixel 113 by a through hole Vial. The through holes Vial in the pixel unit 11 are typically arranged in the same horizontal line (for example, in direction X shown in FIG. 1) and spaced equally. Referring to FIG. 1 and FIG. 2, the through hole Vial corresponding to the first subpixel 111, the through hole Via1 corresponding to the second subpixel 112, and the through hole Vial corresponding to the third subpixel 113 are spaced equally in direction X, that is, L1 = L2. Each interval is 1/3 of the total width of the pixel unit 11 in direction X.

However, for the design of the through holes Via1 spaced equally and arrayed in the same horizontal line, there is a requirement on the spacing between the through hole Via1 and the light-emitting region of the subpixel in addition to the flatness requirement of the display region, but due to the limited space for the Real pixel arrangement, the through hole Via1 connecting to the third subpixel 113 is located adjacent to the anode 113-A; as a result, the pixel aperture in the pixel definition layer (PDL) 14 is reduced, resulting in the aperture area loss in the light-emitting region of the third subpixel 113, as indicated by the range Δ in the Fig. 2. This inevitably affects the service life of the third subpixel 113, leading to a shorter service life of the third subpixel 113, causing color cast, and affecting the display effect.

In view of the preceding, the inventors have discovered through research that the positions of the through holes to which the anodes of the subpixels are connected can be optimized such that the through holes are spaced unequally or arrayed nonlinearly, avoiding the aperture area loss of the subpixels caused by the through holes, improving the aperture ratio and the service life of the subpixels, and alleviating the color cast. Based on this, the inventors provide solutions of embodiments of the present disclosure. Embodiments of the present disclosure provide a display panel. The display panel includes a substrate; and a pixel circuit layer, an insulating layer, and a display function layer that are stacked in sequence on one side of the substrate. The pixel circuit layer includes multiple pixel circuits arranged in an array. The insulating layer includes multiple through holes filled with conductive structures. The display function layer includes multiple light-emitting elements. The pixel circuits are electrically connected to the light-emitting elements by the conductive structures. The display panel includes multiple pixel units. Each pixel unit includes a first light-emitting element, a second light-emitting element, and a third light-emitting element that emit different colors of light. The through holes include a first through hole, a second through hole, and a third through hole that are arranged corresponding to the first light-emitting element, the second light-emitting element, and the third light-emitting element respectively. The projection of the central point of the first through hole on the substrate, the projection of the central point of the second through hole on the substrate, and the projection of the central point of the third through hole on the substrate are point A, point B, and point C respectively. Points A, B, and C are arranged in a first direction. The distance between point A and point B is a. The distance between point B and point C is b. a ≠ b. The first direction is parallel to the row direction or the column direction of the array formed by the pixel circuits.

In the forgoing solution, the positions of the through holes to which the anodes of the subpixels are connected can be optimized such that the through holes are spaced unequally, avoiding the aperture area loss of the subpixels in the PDL caused by the through holes, improving the aperture ratio and the service life of the subpixels, alleviating the color cast, and improving the visual imaging effect of the display panel.

The technical solutions in the embodiments of the present disclosure will now be described with reference to the accompanying drawings.

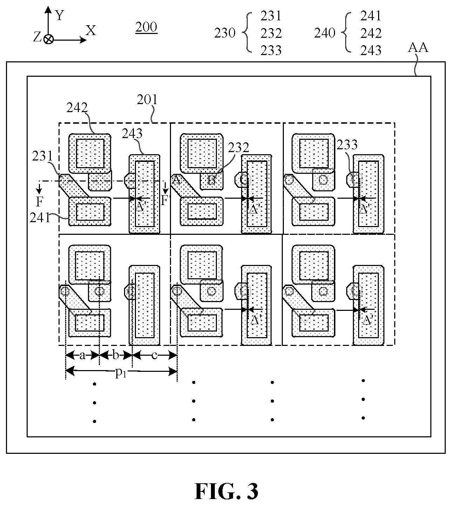

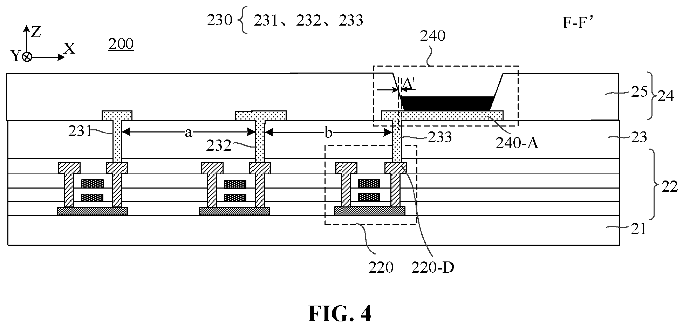

FIG. 3 is a structural diagram of a display panel according to embodiments of the present disclosure. FIG. 4 is a sectional view taken along direction FF' of FIG. 3. Referring to FIG. 3 and FIG. 4, a display panel 200 according to embodiments of the present disclosure includes a substrate 21; and a pixel circuit layer 22, an insulating layer 23, and a display function layer 24 that are stacked in sequence on one side of the substrate 21. The pixel circuit layer 22 includes multiple pixel circuits 210 (not shown) arranged in an array. The insulating layer 23 includes multiple through holes 230 filled with conductive structures 2301. The display function layer 24 includes multiple light-emitting elements 240. The pixel circuits 210 are electrically connected to the light-emitting elements 240 by the conductive structures 2301. The through hole 230 may be referred to as a through hole in direct contact with an anode. The display panel 200 includes multiple pixel units 201. Each pixel unit 201 includes a first light-emitting element 241, a second light-emitting element 242, and a third light-emitting element 243 that emit different colors of light. The through holes 230 include a first through hole 231, a second through hole 232, and a third through hole 233 that are arranged corresponding to the first light-emitting element 241, the second light-emitting element 242, and the third light-emitting element 243 respectively. The projection of the central point of the first through hole 231 on the substrate 21, the projection of the central point of the second through hole 232 on the substrate 21, and the projection of the central point of the third through hole 233 on the substrate 21 are point A, point B, and point C respectively. Points A, B, and C are arranged in a first direction X. The distance between point A and point B is a. The distance between point B and point C is b. a ≠ b. The first direction X is parallel to the row direction or the column direction of the array formed by the pixel circuits.

The display panel 200 may be, but not limited to, an organic light-emitting diode (OLED) display panel, an active-matrix organic light-emitting diode (AMOLED) display panel, or the like, and the type of the display panel 200 is not limited herein. The substrate 21 of the display panel may be made of a rigid material such as glass or silicon wafer or made of a flexible material such as ultra-thin glass, metal foil, or polymer. The substrate 21 made of a rigid material or a flexible material can block oxygen and moisture and prevent moisture or impurities from diffusing into the interior of the display panel through the substrate 21.

Referring to FIG. 3 and FIG. 4, the display panel 200 includes a display region AA. The display region AA is used for normal display. The display region AA includes multiple pixel units 201. Each pixel unit 201 includes at least three light-emitting elements 240. Illustratively, referring to FIG. 3, the pixel unit 201 includes a first light-emitting element 241, a second light-emitting element 242, and a third light-emitting element 243. The first light-emitting element 241 may be a red subpixel (R). The second light-emitting element 242 may be a green subpixel (G). The third light-emitting element 243 may be a blue subpixel (B). The display panel 200 further includes a pixel circuit layer 22 on one side of the substrate 21. The pixel circuit layer 22 includes pixel circuits 210 having circuit structures such as 2T1C, 4T1C, 7T1C, 7T2C, 8T1C, and 8T2C. Each pixel circuit 210 includes multiple thin-film transistors 220 and film structures (not shown) including storage capacitors and metal wires. The thin-film transistor 220 is electrically connected to the anode 240-A of a light-emitting element 240 by a through hole 230. In some embodiments, the pixel circuit 210 corresponding to the first light-emitting element 241, the pixel circuit 210 corresponding to the second light-emitting element 242, and the pixel circuit 210 corresponding to the third light-emitting element 243 are closest to each other in sequence and have the same layout.

Referring to FIG. 3 and FIG. 4, taking the first through hole 231 arranged corresponding to the first light-emitting element 241, the second through hole 232 arranged corresponding to the second light-emitting element 242, and the third through hole 233 arranged corresponding to the third light-emitting element 243 as an example, limited by the parallelism of the row direction or the column direction of the array formed by the pixel circuits, if the third through hole 233 is arranged adjacent to the third light-emitting element 243, the aperture area in the light-emitting region of the pixel definition layer 25 is occupied, which affects the aperture ratio of the light-emitting region of the light-emitting element 240. Referring to FIG. 3, embodiments of the present disclosure break through the arrangement pattern of equally spacing the through holes in the related art, the projection of the central point of the first through hole 231 on the substrate 21, the projection of the central point of the second through hole 232 on the substrate 21, and the projection of the central point of the third through hole 233 on the substrate 21, which are indicated by point A, point B, and point C respectively, are arranged in the direction X as shown. For the case where the third through hole 233 blocks the third light-emitting element 243, it is feasible to change the position of the through hole 230 by making the distance a between point A (the projection of the central point of the first through hole 231 on the substrate 21) and point B (the projection of the central point of the second through hole 232 on the substrate 21) unequal to the distance b between point B (the projection of the central point of the second through hole 232 on the substrate 21) and point C (the projection of the central point of the third through hole 233 on the substrate 21). That is, a ≠ b. This breaks through the arrangement pattern of equally spacing the through holes 230, reduces the blocking on the third light-emitting element 243 caused by the third through hole 233, increases the aperture ratio of the light-emitting region of the light-emitting element 240, increases the light-emitting area of the light-emitting elements, and increases the service life.

FIG. 3 and FIG. 4 illustrate an example in which the third through hole 233 affects the aperture ratio of the light-emitting region of the third light-emitting element 243 and the service life of the third light-emitting element 243. In some embodiments, it is feasible that the third through hole 233 is arranged to be closer to the second through hole 232 in direction X. In other embodiments, if the first through hole 231 and/or the second through hole 232 affects the aperture ratio of the light-emitting region of the corresponding light-emitting element 240 and the service life of the corresponding light-emitting element 240, it is also feasible to rearrange the first through hole 231 and/or the second through hole 232 to avoid the design of equally-spaced through holes to increase the aperture ratio of the light-emitting region of the corresponding light-emitting element 240 and the service life of the corresponding light-emitting element 240. Examples are not enumerated.

The display panel 200 of this embodiment further includes other films such as the pixel definition layer 25, an organic material layer of light-emitting elements, cathodes, and a thin-film encapsulation layer. These films work together to provide the display function of the display device. The details are not described here.

In conclusion, in the display panel of embodiments of the present disclosure, the positions of the through holes to which the anodes of light-emitting elements in the pixel unit are connected are optimized such that the through holes are spaced unequally, avoiding the aperture area loss of the light-emitting regions of the light-emitting elements caused by the through holes, improving the aperture ratio and the service life of the subpixels, alleviating the color cast of the subpixels, and improving the display effect of the display panel.

Based on the previous embodiments, referring to FIG. 3, the first light-emitting elements 241 alternate with the second light-emitting elements 242 in a second direction Y, the plurality of third light-emitting elements 243 are arranged in the second direction Y, the first light-emitting elements 241 alternate with the third light-emitting elements 243 in the first direction X, and the second light-emitting elements 242 alternate with the third light-emitting elements 243 in the first direction X. The second direction Y intersects the first direction X.

Referring to FIG. 3, the pixel units 201 of the display panel 200 are arranged in a Real pixel arrangement. This arrangement facilitates small-size high-definition display of the display panel and satisfies the application requirements of the wearable product.

In some embodiments, a > b.

Referring to FIG. 3 and FIG. 4, the third through hole 233 may be arranged closer to the second through hole 232 in the direction X such that the distance a between point A (the projection of the central point of the first through hole 231 on the substrate 21) and point B (the projection of the central point of the second through hole 232 on the substrate 21) can be greater than the distance b between point B (the projection of the central point of the second through hole 232 on the substrate 21) and point C (the projection of the central point of the third through hole 233 on the substrate 21), so that the proportion of the third through hole 233 in the light-emitting region of the third light-emitting element 243 can be reduced. That is, the range Δ' in FIG. 3 may be smaller than the range Δ in FIG. 1 so that the aperture ratio and light-emitting area of the light-emitting region of the third light-emitting element 243 can be increased.

In some embodiments, when the position adjustment of the third through hole 233 is relatively small, it is feasible to rearrange the third through hole 233 in the insulating layer 23 to reduce the proportion of the third through hole 233 in the light-emitting region of the third light-emitting element 243. In some embodiments, when the position adjustment of the third through hole 233 is relatively large, it is feasible to increase the area of the source/drain of the thin-film transistor 220 to ensure the electrical connection between the source/drain and the conductive structure in the third through hole 233. Such structural adjustment can reduce the proportion of the third through hole 233 in the light-emitting region of the third light-emitting element 243 without excessively adjusting the underlying pixel circuit arrangement so that the aperture ratio and light-emitting area of the light-emitting region of the third light-emitting element 243 can be increased, the service life of the third light-emitting element 243 can be improved, and the color cast can be alleviated.

Based on the previous embodiments, referring to FIG. 3, the first light-emitting element 241 is a red light-emitting element R or a green light-emitting element G, the second light-emitting element 242 is the other one of the red light-emitting element R or the green light-emitting element G, and the third light-emitting element 243 is a blue light-emitting element Blue.

Referring to FIG. 3, the first light-emitting element 241 is a red light-emitting element R, the second light-emitting element 242 is a green light-emitting element G, and the third light-emitting element 243 is a blue light-emitting element Blue.

According to a test by comparing FIGs. 3-4 according to embodiments of the present disclosure with FIGs. 1-2, as shown in Table 1, in the direction X, the aperture loss of the blue subpixel (Blue) is reduced to Δ' = 2.75 um as compared with Δ = 3.85 um in the related art, the aperture ratio of the blue subpixel is predicted to be increased by about 0.5%, the service life of the blue subpixel (B) is predicted to be increased by 8%, and the color cast is predicted to be increased by 15%. It can be seen that the arrangement of the unequally spaced through holes can increase the service life of the blue subpixel and alleviate the color cast of the blue subpixel. W in Table 1 indicates the service life of white light.

**Table 1**

| | R | G | B | W |
|---|---|---|---|---|
| Related Art | 1084 | 796 | 356 | 776 |
| Embodiments of the Present disclosure | 1084 | 796 | 384 | 784 |
| Improvement Ratio | / | / | 8% | 1% |

Each value in Table 1 indicates a service life. The larger the value, the longer the service life of the light-emitting element, and the better the luminous performance of the light-emitting element.

Based on the previous embodiments, referring to FIG. 3, in the first direction X, at least part of the light-emitting region of the first light-emitting element 241 and at least part of the light-emitting region of the second light-emitting element 242 overlap the light-emitting region of the third light-emitting element 243.

Referring to FIG. 3, in each single pixel unit 201, the third light-emitting element 243 overlaps both the first light-emitting element 241 and the second light-emitting element 242 along the direction X; and along the direction Y, the first light-emitting element 241 overlaps the second light-emitting element 242, and the third light-emitting element 243 extends in the direction Y. The three light-emitting elements 240 in each single pixel unit 201 are arranged in a compact manner, thereby improving the brightness of the mixed light of each single pixel unit 201 and improving the pixel resolution of the display panel 200.

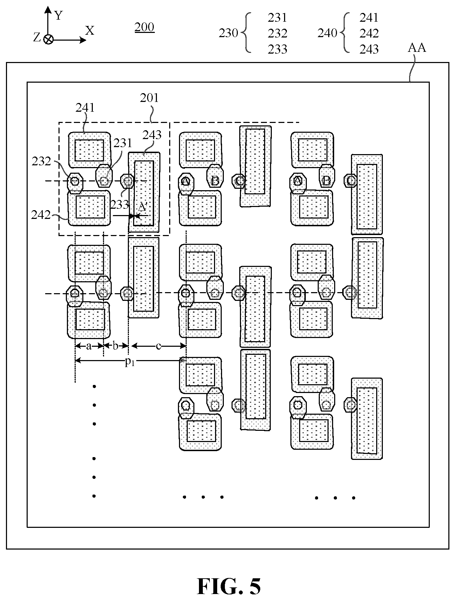

FIG. 5 is a structural diagram of another display panel according to embodiments of the present disclosure. Based on the previous embodiments, referring to FIG. 3 and FIG. 5, points A, B, and C are located in the same straight line parallel to the first direction X.

Referring to FIG. 3, FIG. 4, and FIG. 5, according to the array arrangement pattern of the pixel circuits in the row and column directions, the projection (point A) of the central point of the first through hole 231 on the substrate 21, the projection (point B) of the central point of the second through hole 232 on the substrate 21, and the projection (point C) of the central point of the third through hole 233 on the substrate 21 are located in the same straight line parallel to the first direction X.

Further, referring to FIG. 3, FIG. 4, and FIG. 5, in two adjacent pixel units 201 in the first direction X, the distance between two corresponding points A is p₁, and the distance between point C in the first pixel unit 201 and point A in the second pixel unit 201 is c. a ≠ b ≠ c, and a + b + c = p₁.

According to the array arrangement pattern of the pixel circuits in the row and column directions, the projection (point A) of the central point of the first through hole 231 on the substrate 21, the projection (point B) of the central point of the second through hole 232 on the substrate 21, and the projection (point C) of the central point of the third through hole 233 on the substrate 21 are located in the same straight line parallel to the first direction, and the distances between the through holes 230 corresponding to the pixel unit 201 and the through holes 230 of the adjacent pixel unit 201 satisfy a relationship: a + b + c = p₁. In this manner, the reduction in aperture ratio of the light-emitting region of the light-emitting element 240 caused by the through hole can be alleviated. Moreover, with the linear array arrangement of the through holes, the preparation difficulty of the display panel 200 can be reduced, and the production cost of the display panel 200 can be reduced.

The arrangement of the third light-emitting elements 243 of FIG. 5 is different from the arrangement of the third light-emitting elements 243 of FIG. 3.

Based on the previous embodiments, referring to FIG. 3, a, b, and c satisfy at least one of the following conditions: a = 1/3p₁, b < 1/3p₁, or c > 1/3p₁.

The position relationship between the first through hole 231, the second through hole 232, and the third through hole 233 may be set appropriately. In some embodiments, a = 1/3p₁, b < 1/3p₁, or c > 1/3p₁. With such settings, the distance between the third through hole 233 and the second through hole 232 can be shortened so that the proportion of the third through hole 233 in the light-emitting region of the third light-emitting element 243 can be reduced, and the aperture ratio and light-emitting area of the light-emitting region of the third light-emitting element 243 can be increased.

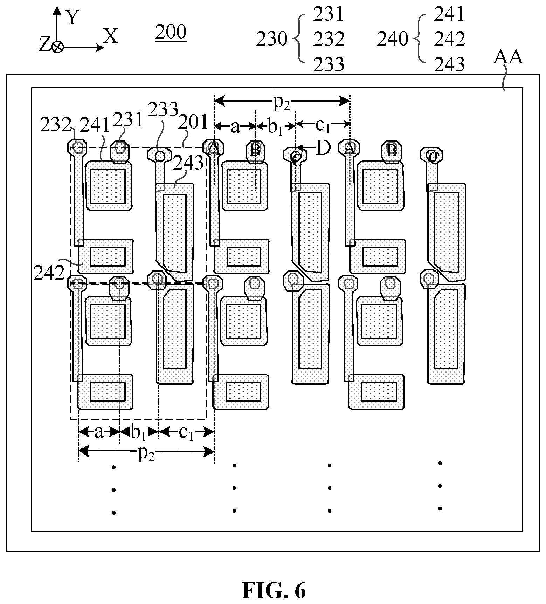

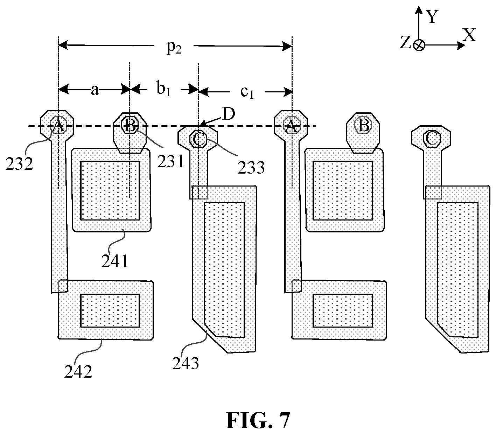

FIG. 6 is a structural diagram of another display panel according to embodiments of the present disclosure. FIG. 7 is an enlarged view of two adjacent pixel units of FIG. 6. Based on the previous embodiments, referring to FIG. 6 and FIG. 7, points A and B are located in the same straight line parallel to the first direction X, point C is located outside the straight line where points A and B are located, and the vertical projection of point C on the straight line where points A and B are located is point D. Points A and B are located in a straight line parallel to the first direction X, while point C is located outside the straight line where points A and B are located.

FIG. 6 shows another arrangement of pixel units 201. Referring to FIG. 6 and FIG. 7, in an example in which the first light-emitting element 241 is a red light-emitting element R, the second light-emitting element 242 is a green light-emitting element G, and the third light-emitting element 243 is a blue light-emitting element Blue, according to the array arrangement pattern of the pixel circuits in the row and column directions, the projection (point A) of the central point of the first through hole 231 on the substrate 21 and the projection (point B) of the central point of the second through hole 232 on the substrate 21 are located in the same straight line parallel to the first direction X, the projection (point C) of the central point of the third through hole 233 on the substrate 21 is located outside this straight line, the through holes 230 for the three light-emitting elements R, G, and Blue in the same pixel unit 201 are not in the same horizontal line, and two blue light-emitting elements that are connected to each other are staggered in the direction Y.

Further, referring to FIG. 6 and FIG. 7, in two adjacent pixel units 201 in the first direction X, the distance between two corresponding points A is p₂, the distance between point B in a first pixel unit 201 and point D in the first pixel unit 201 is b₁, and the distance between point D in the first pixel unit 201 and corresponding point A in a second pixel unit 201 is c₁. a ≠ b₁ ≠ c₁, and a + b₁ + c₁ = p₂.

Referring to FIG. 6 and FIG. 7, the distances between the through holes of the pixel unit 201 and the adjacent pixel unit 201 in the direction X is configured to satisfy that a + b₁ + c₁ = p₂. The position of the third through hole 233 relative to the third light-emitting element 243 may be adjusted so that the aperture ratio and light-emitting area of the light-emitting region of the third light-emitting element 243 can be increased, and the reduction in the aperture ratio of the light-emitting region of the light-emitting element 240 caused by the through hole can be alleviated.

Referring to FIG. 6 and FIG. 7, the position relationship between the first through hole 231, the second through hole 232, and the third through hole 233 is set appropriately such that a, b₁, and c₁ satisfy at least one of the following conditions: a = 1/3p₂, b₁ < 1/3p₂, or c₁ > 1/3p₂. With such settings, the distance between the third through hole 233 and the second through hole 232 in the direction X can be shortened so that the proportion of the third through hole 233 in the light-emitting region of the third light-emitting element 243 can be reduced, third light-emitting elements 243 in two adjacent pixel units 201 can be staggered, and the aperture ratio of the light-emitting region of the third light-emitting element 243 can be increased.

In some embodiments, referring to FIG. 6 and FIG. 7, the distance d₁ between point C and point D is less than 10 µm so that the through hole is prevented from affecting the aperture ratio of the light-emitting element in the adjacent pixel unit. d₁ is not shown in the figure.

Referring to FIG. 6 and FIG. 7, the first light-emitting element 241 is a red light-emitting element R, the second light-emitting element 242 is a green light-emitting element G, and the third light-emitting element 243 is a blue light-emitting element Blue. According to a test by comparing FIG. 6 of embodiments of the present disclosure with FIG. 1 and FIG. 2, as shown in Table 2, the service life of the blue subpixel (B) is predicted to be increased by 11%, and the color cast is predicted to be increased by 21%. It can be seen that the nonlinear array arrangement of the through holes 230 can minimize the aperture loss of the blue subpixel (B), increase the service life of the blue subpixel (B), and alleviate the color cast of the blue subpixel (B). W in Table 2 indicates the service life of white light.

**Table 2**

| | R | G | B | W |
|---|---|---|---|---|
| Related Art | 1084 | 796 | 356 | 776 |
| Embodiments of the Present disclosure | 1084 | 796 | 396 | 784 |
| Improvement Ratio | / | / | 11% | 1% |

Each value in Table 2 indicates a service life. The larger the value, the longer the service life of the light-emitting element, and the better the luminous performance of the light-emitting element.

The pixel arrangement of the display panel 200 of embodiments of the present disclosure may be, but not limited to, the Real pyramid pixel arrangement. Any time the through holes 230 in the pixel circuits 210 cause the aperture loss of the light-emitting region of the subpixel, the through holes may be spaced unequally in the manner used by the previous embodiments, thereby reducing the aperture loss of the subpixel caused by the through holes, increasing the service life of the subpixel, and alleviating the color cast. According to different pixel arrangements of the display panel 200, the display region may have different virtual shapes including, but not limited to, a quadrangle, a polygon, and a circle, and the present disclosure is not limited in this aspect.

Based on the same inventive concept, embodiments of the present disclosure provide another display panel. In the display panel, the positions of the through holes to which the anodes of the subpixels are connected are adjusted such that the through holes are spaced unequally or arrayed nonlinearly, avoiding the aperture area loss of the subpixel in the PDL caused by the through holes, improving the aperture ratio and the service life of the subpixel, and alleviating the color cast.

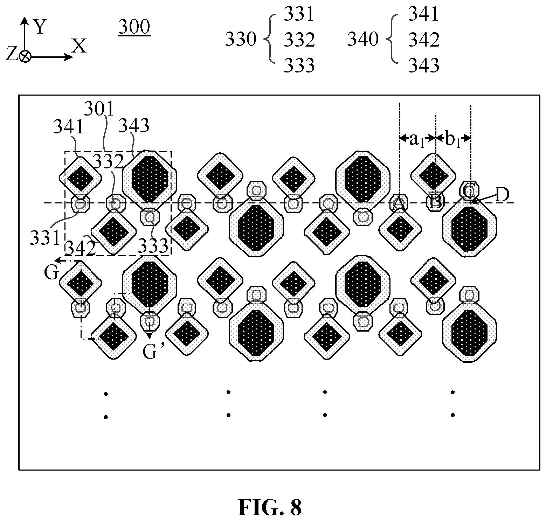

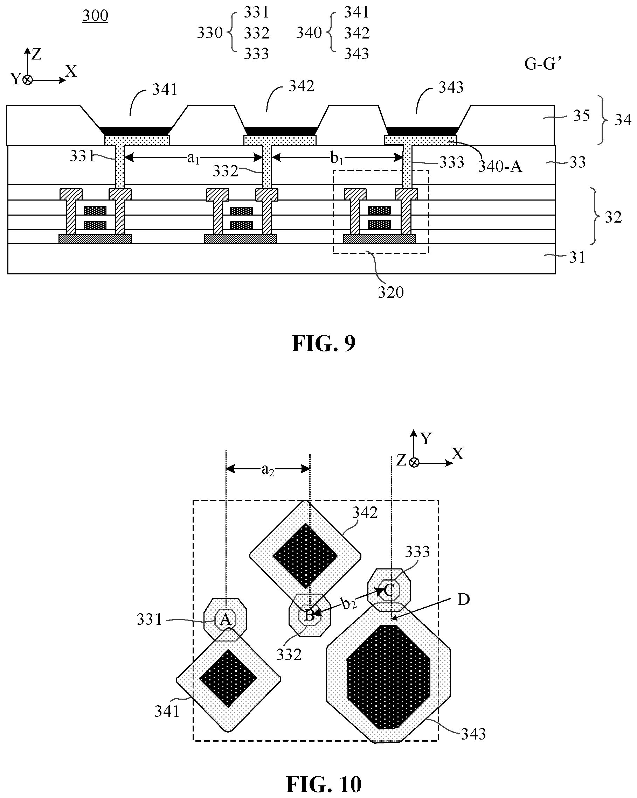

FIG. 8 is a structural diagram of another display panel according to embodiments of the present disclosure. FIG. 9 is a sectional view taken along direction GG' of FIG. 8. In some embodiments, referring to FIG. 8 and FIG. 9, another display panel 300 according to embodiments of the present disclosure includes a substrate 31; and a pixel circuit layer 32, an insulating layer 33, and a display function layer 34 that are stacked in sequence on one side of the substrate 31. The pixel circuit layer 32 includes multiple pixel circuits arranged in an array. The insulating layer 33 includes multiple through holes 330. The through holes 330 are filled with conductive structures 3301. The display function layer 34 includes multiple light-emitting elements 340. The pixel circuits 310 are electrically connected to the light-emitting elements 340 by the conductive structures 3301. The through hole 330 may be referred to as a through hole in direct contact with an anode. The display panel 300 includes multiple pixel units 301. The pixel unit 301 includes a first light-emitting element 341, a second light-emitting element 342, and a third light-emitting element 343 that emit different colors of light. The through holes 330 include a first through hole 331, a second through hole 332, and a third through hole 333 that are arranged corresponding to the first light-emitting element 341, the second light-emitting element 342, and the third light-emitting element 343 respectively. The projection of the central point of the first through hole 331 on the substrate 31, the projection of the central point of the second through hole 332 on the substrate 31, and the projection of the central point of the third through hole 333 on the substrate 31 are point A, point B, and point C respectively. Points A, B, and C are arranged in a first direction X. Points A and B are located in one straight line parallel to the first direction. Point C is located outside the straight line where points A and B are located. The first direction X is parallel to the row direction or the column direction of the array formed by the pixel circuits 310.

The display panel 300 may be, but not limited to, an organic light-emitting diode (OLED) display panel or an active-matrix organic light-emitting diode (AMOLED) display panel. The substrate 31 of the display panel 300 may be made of a rigid material such as glass or silicon wafer, or made of a flexible material such as ultra-thin glass, metal foil, or polymer. The substrate 31 made of a rigid material or a flexible material can block oxygen and moisture and prevent moisture or impurities from diffusing into the interior of the display panel 300 through the substrate 31.

Referring to FIG. 8 and FIG. 9, the display panel 300 includes a display region AA. The display region AA is used for normal display. The display panel 300 includes multiple pixel units 301. One pixel unit 301 includes three light-emitting elements 340. Illustratively, referring to FIG. 8, the pixel unit 301 includes a first light-emitting element 341, a second light-emitting element 342, and a third light-emitting element 343. Illustratively, the first light-emitting element 341 is a red subpixel (R), the second light-emitting element 342 is a green subpixel (G), and the third light-emitting element 343 is a blue subpixel (B). The display panel 300 further includes a pixel circuit layer 32 on one side of the substrate 31. The pixel circuit layer 32 includes pixel circuits 310. The pixel circuits 310 may have a circuit structure such as 2T1C, 4T1C, 7T1C, 7T2C, 8T1C, or 8T2C. A pixel circuit 310 includes multiple thin-film transistors 320 and film structures (not shown) including storage capacitors and metal wires. The thin-film transistor 320 is electrically connected to the anode 340-A of a light-emitting element 340 by a through hole 330. The pixel circuit layer 32 is configured to provide drive voltages to light-emitting elements 340 to drive the light-emitting elements 340 to emit light.

Referring to FIG. 8 and FIG. 9, taking the first through hole 331 arranged corresponding to the first light-emitting element 341, the second through hole 332 arranged corresponding to the second light-emitting element 342, and the third through hole 333 arranged corresponding to the third light-emitting element 343 as an example, limited by the parallelism of the row direction or the column direction of the array formed by the pixel circuits, if the third through hole 333 is arranged adjacent to the third light-emitting element 343, the aperture area in the light-emitting region in the pixel definition layer 35 is occupied, which affects the aperture ratio of the light-emitting region of the light-emitting element 340. Referring to FIG. 8, embodiments of the present disclosure break through the arrangement pattern of equally spacing the through holes in the related art. By changing the position of the through hole 330 appropriately, the projection (point A) of the central point of the first through hole 331 on the substrate 31 and the projection (point B) of the central point of the second through hole 332 on the substrate 31 are located in a straight line parallel to the first direction X, and the projection (point C) of the central point of the third through hole 333 on the substrate 31 is located outside this straight line where the points A and B are located. The third through hole 333 is arranged to be staggered with respect to the first through hole 331 and the second through hole 332, so that the proportion of the third through hole 333 in the light-emitting region of the third light-emitting element 343 can be reduced, the aperture ratio of the light-emitting region of the third light-emitting element 343 can be increased, and the service life of the third light-emitting element 343 can be improved.

In FIG. 8 and FIG. 9, by way of example, the third through hole 333 affects the aperture ratio of the light-emitting region of the third light-emitting element 343 and the service life of the third light-emitting element 343. In some embodiments, it is feasible to rearrange the third through hole 333 in the direction Y. In other embodiments, when the first through hole 331 and/or the second through hole 332 affects the aperture ratio of the light-emitting region of the corresponding light-emitting element 340 and the service life of the corresponding light-emitting element 340, it is feasible to rearrange the first through hole 331 and/or the second through hole 332 to avoid the design of equally-spaced through holes to increase the aperture ratio of the light-emitting region of the corresponding light-emitting element 340 and the service life of the corresponding light-emitting element 340. Examples are not enumerated.

The display panel 300 of this embodiment also includes other films such as a pixel definition layer 35, an organic layer of light-emitting elements, cathodes, and a thin-film encapsulation layer. These films work together to provide the display function of the display device. The details are not described here.

In conclusion, in the display panel of embodiments of the present disclosure, the positions of the through holes to which the anodes of the subpixels in the pixel unit are connected are adjusted such that the through holes are arrayed nonlinearly, avoiding the aperture loss of the light-emitting regions of the light-emitting elements caused by the through holes, improving the aperture ratio and the service life of the subpixels, alleviating the color cast of the subpixels, and improving the display effect of the display panel.

Based on the previous embodiments, referring to FIG. 8, in the same pixel unit 301, connection lines between the center of the first light-emitting element 341, the center of the second light-emitting element 342, and the center of the third light-emitting element 343 form a triangle; and in the pixel units 301, first light-emitting elements 341, second light-emitting elements 342, and third light-emitting elements 343 alternate in the first direction X and are arranged in a second direction Y. The second direction Y intersects the first direction X.

Referring to FIG. 8, the pixel units 301 of the display panel 300 are arranged in a Real pyramid pixel arrangement. This arrangement facilitates a compact arrangement of the three light-emitting elements 340 in each single pixel unit 301, improves the brightness of each single pixel unit 301, facilitates small-size and high-definition display of the display panel, and satisfies the application requirements of the wearable product.

In some embodiments, referring to FIG. 8 and FIG. 9, the vertical projection of point C on the straight line where points A and B are located is point D; and the distance between point A and point B is a₁, and the distance between point D and point B is b₁, where a₁ = b₁.

Referring to FIG. 8, at least one of points A, B, and C is not in the same straight line as others of the points A, B, and C, and along the direction X, the distance a₁ between the center point of the first through hole 331 and the center point of the second through hole 332 is the same as the distance b₁ between the center point of the second through hole 332 and the center point of the third through hole 333.

In some embodiments, in the direction Y, the distance d₂ between point C and point D is less than 12 µm, preventing the through hole from affecting the aperture ratio of the light-emitting element in the adjacent pixel unit. d₂ is not shown in FIG. 8.

FIG. 10 is an enlarged view of a single pixel unit of FIG. 8. In some embodiments, referring to FIG. 10, the distance between point A and point B is a₂, and the distance between point B and point C is b₂. a₂ = b₂.

Referring to FIG. 8, at least one of points A, B, and C is not in the same straight line as others of the points A, B, and C, and the distance a₁ between the center point of the first through hole 331 and the center point of the second through hole 332 is the same as the distance b₂ between the center point of the second through hole 332 and the center point of the third through hole 333.

In summary, the layout of the through holes in the Real pyramid pixel arrangement is optimized such that the through holes corresponding to the blue light-emitting elements are staggered, and the through holes in the Real pyramid pixel arrangement are spaced unequally or arranged nonlinearly. In this manner, the aperture loss of the blue light-emitting elements can be effectively avoided, the aperture ratio of the blue light-emitting elements can be increased, and thus the service life and the color cast of the blue light-emitting elements can be improved.

The display panel according to the embodiments of the present disclosure includes a substrate; and a pixel circuit layer, an insulating layer, and a display function layer that are stacked in sequence on one side of the substrate. A first through hole, a second through hole, and a third through hole in the insulating layer correspond to a first light-emitting element, a second light-emitting element, and a third light-emitting element in the display function layer respectively. The projection of the central point of the first through hole on the substrate, the projection of the central point of the second through hole on the substrate, and the projection of the central point of the third through hole on the substrate are point A, point B, and point C respectively. Points A, B, and C are arranged in a first direction. The distance between point A and point B is a, and the distance between point B and point C is b, where a ≠ b; or points A and B are located in a straight line parallel to the first direction, and point C is located outside the straight line where points A and B are located. The positions of the through holes to which the anodes of subpixels are connected are optimized such that the through holes are spaced unequally or arrayed nonlinearly, avoiding the subpixel aperture area loss caused by the through holes, improving the aperture ratio and the service life of the subpixels, alleviating the color cast, and improving the display effect of the display panel.

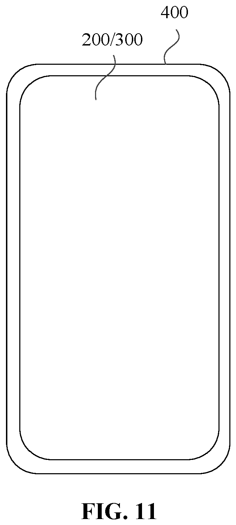

Based on the same inventive concept, embodiments of the present disclosure also provide a display device. FIG. 11 is a structural diagram of a display device according to embodiments of the present disclosure. Referring to FIG. 11, the display device includes the display panel of any previous embodiment. Illustratively, referring to FIG. 11, the display device 400 includes a display panel 200 or a display panel 300. Therefore, the display device has the beneficial effects of the display panel of any previous embodiment. For the same details, reference may be made to the preceding description of the display panel.

The display device 400 of this embodiment of the present disclosure may be a phone shown in FIG. 11 or may be any electronic product with a display function, including, but not limited to a television, a laptop, a desktop display, a tablet computer, a digital camera, a smart bracelet, smart glasses, an in-vehicle display, industry-controlling equipment, a medical display, or a touch interactive terminal. This is not limited in this embodiment of the present disclosure.

## Claims

1. A display panel, comprising:
a substrate; and
a pixel circuit layer, an insulating layer, and a display function layer that are stacked in sequence on one side of the substrate,
wherein
the pixel circuit layer comprises a plurality of pixel circuits arranged in an array, the insulating layer comprises a plurality of through holes, the plurality of through holes are filled with conductive structures, the display function layer comprises a plurality of light-emitting elements, and the plurality of pixel circuits are electrically connected to the plurality of light-emitting elements by the conductive structures;
the display panel comprises a plurality of pixel units, each pixel unit of the plurality of pixel units comprises a first light-emitting element, a second light-emitting element, and a third light-emitting element that emit different colors of light, the plurality of through holes comprise a first through hole, a second through hole, and a third through hole that are arranged corresponding to the first light-emitting element, the second light-emitting element, and the third light-emitting element respectively, and a projection of a central point of the first through hole on the substrate, a projection of a central point of the second through hole on the substrate, and a projection of a central point of the third through hole on the substrate are point A, point B, and point C respectively, and
the point A, the point B, and the point C are arranged in a first direction, a distance between the point A and the point B is a, and a distance between the point B and the point C is b, wherein a ≠ b, and the first direction is parallel to a row direction or a column direction of the array formed by the plurality of pixel circuits.

2. The display panel of claim 1, wherein among the plurality of light-emitting elements, first light-emitting elements alternate with second light-emitting elements in a second direction, third light-emitting elements are arranged in the second direction, the first light-emitting elements alternate with the third light-emitting elements in the first direction, and the second light-emitting elements alternate with the third light-emitting elements in the first direction, wherein the second direction intersects the first direction.

3. The display panel of claim 2, wherein a > b.

4. The display panel of claim 2, wherein the first light-emitting element is one of a red light-emitting element or a green light-emitting element, the second light-emitting element is the other one of the red light-emitting element or the green light-emitting element, and the third light-emitting element is a blue light-emitting element.

5. The display panel of claim 2, wherein in the first direction, at least part of a light-emitting region of the first light-emitting element and at least part of a light-emitting region of the second light-emitting element overlap a light-emitting region of the third light-emitting element.

6. The display panel of claim 2, wherein the point A, the point B, and the point C are located in a same straight line parallel to the first direction; and
in two adjacent pixel units in the first direction among the plurality of pixel units, a distance between two points A is p₁, and a distance between point C in a first pixel unit and point A in a second pixel unit is c, wherein a ≠ b ≠ c, and a + b + c = p₁.

7. The display panel of claim 6, wherein a, b, and c satisfy at least one of the following conditions: $a = {1 / 3 p}_{1} ,$ $b < 1 / 3 {p}_{1} ,$ or $c > 1 / 3 {p}_{1} .$

8. The display panel of claim 2, wherein the point A and the point B are located in a same straight line parallel to the first direction, the point C is located outside the straight line where the point A and the point B are located, and a vertical projection of the point C on the straight line where the point A and the point B are located is point D; and
in two adjacent pixel units in the first direction among the plurality of pixel units, a distance between two points A is p₂, a distance between point B in a first pixel unit and point D in the first pixel unit is b₁, and a distance between the point D in the first pixel unit and point A in a second pixel unit is c₁, wherein a ≠ b₁ ≠ c₁, and a + b₁ + c₁ = p₂.

9. The display panel of claim 8, wherein a, b₁, and c₁ satisfy at least one of the following conditions: $a = 1 / 3 {p}_{2} ,$ ${b}_{1} < 1 / 3 {p}_{2} ,$ or ${c}_{1} > 1 / 3 {p}_{2} .$

10. The display panel of claim 8, wherein a distance d₁ between the point C and the point D is less than 10 µm.

11. The display panel of claim 1, wherein the point A, the point B, and the point C are located in a same straight line parallel to the first direction.

12. The display panel of claim 1, wherein the point A and the point B are located on a straight line parallel to the first direction, and the point C is located outside the straight line where the point A and the point B are located.

13. A display panel, comprising:
a substrate; and
a pixel circuit layer, an insulating layer, and a display function layer that are stacked in sequence on one side of the substrate,
wherein
the pixel circuit layer comprises a plurality of pixel circuits arranged in an array, the insulating layer comprises a plurality of through holes, the plurality of through holes are filled with conductive structures, the display function layer comprises a plurality of light-emitting elements, and the plurality of pixel circuits are electrically connected to the plurality of light-emitting elements by the conductive structures; and
the display panel comprises a plurality of pixel units, each pixel unit of the plurality of pixel units comprises a first light-emitting element, a second light-emitting element, and a third light-emitting element that emit different colors of light, the plurality of through holes comprise a first through hole, a second through hole, and a third through hole that are arranged corresponding to the first light-emitting element, the second light-emitting element, and the third light-emitting element respectively, and a projection of a central point of the first through hole on the substrate, a projection of a central point of the second through hole on the substrate, and a projection of a central point of the third through hole on the substrate are point A, point B, and point C respectively, and
the point A, the point B, and the point C are arranged in a first direction, the point A and the point B are located in a straight line parallel to the first direction, and the point C is located outside the straight line where the point A and the point B are located, wherein the first direction is parallel to a row direction or a column direction of the array formed by the plurality of pixel circuits.

14. The display panel of claim 13, wherein in a same pixel unit of the plurality of pixel units, connection lines between a center of the first light-emitting element, a center of the second light-emitting element, and a center of the third light-emitting element form a triangle; and
among the plurality of pixel units, first light-emitting elements, second light-emitting elements, and third light-emitting elements alternate in the first direction and are all arranged in a second direction, wherein the second direction intersects the first direction.

15. The display panel of claim 14, wherein a vertical projection of the point C on the straight line where the point A and the point B are located is point D; and
a distance between the point A and the point B is a₁, and a distance between the point D and the point B is b₁, wherein a₁ = b₁.

16. The display panel of claim 15, wherein a distance d₂ between the point C and the point D is less than 12 µm.

17. The display panel of claim 13, wherein a distance between the point A and the point B is a₂, and a distance between the point B and the point C is b₂, wherein a₂ = b₂.

18. A display device, comprising the display panel according to any one of claims 1 to 17.
